# FASCICULE DE BREVET EUROPEEN

(11) **EP 0 720 290 B1**
(45) Date de publication et mention de la délivrance du brevet: **28.02.2001**
(21) Numéro de dépôt: 95410153.1
(22) Date de dépôt: 27.12.1995
(51) Int. Cl.: H03K 5/08, H04N 7/00, H04N 7/035

(54) **Circuit de restitution de bits transmis par un signal sériel**
Rückgewinnungsschaltung für durch serielles Signal übertragene Bits
Serial signal transmitted bit restoration circuit

(30) Priorité: 30.12.1994 FR 9416012
(43) Date de publication de la demande: 03.07.1996
(73) Titulaire: STMicroelectronics S.A., 94250 Gentilly (FR)
(72) Inventeur: Lagarde, Jean-Pierre, F-38950 Saint Martin le Vinoux (FR)
(74) Mandataire: de Beaumont, Michel

(56) Documents cités:
- EP-A- 0 531 549
- US-A- 4 418 406
- US-A- 5 223 930

## Description

La présente invention concerne un circuit destiné à restituer les niveaux logiques de bits transmis par un signal de manière asynchrone et en série. La présente invention vise plus particulièrement un tel circuit permettant de restituer convenablement les bits même si le signal de transmission subit des fluctuations d'amplitude et de phase.

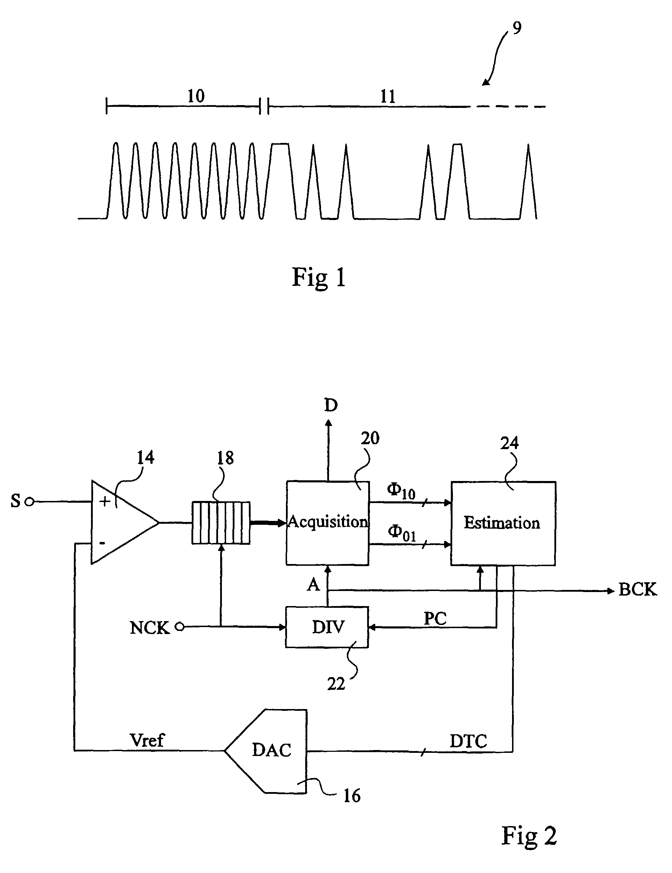

La figure 1 représente un exemple d'allure de signal de transmission. Cet exemple particulier de signal est utilisé pour transmettre des informations de télétexte. Chaque ligne d'informations de télétexte canmence par une salve de synchronisation 10 suivie par les informations télétexte 11.

Selon les conditions de réception, un signal télétexte peut être bruité, et d'amplitude et de phase variables. Grâce à la salve de synchronisation 10 au début de chaque ligne de télétexte, le circuit de réception de ce signal peut réajuster périodiquement sa phase de réception et un seuil de discrimination destiné à distinguer les niveaux logiques hauts des niveaux logiques bas dans le signal télétexte.

Le brevet US 5 136 382 décrit un tel circuit de réception de signaux télétexte. La fréquence et le seuil de discrimination trouvés en début de chaque ligne sont maintenus pendant toute la durée de la ligne, jusqu'à la salve d'impulsions de synchronisation suivante. Ainsi, ce circuit ne compense pas d'éventuelles fluctuations d'amplitude et de phase du signal télétexte pendant la durée d'une ligne, ce qui peut provoquer de nombreuses erreurs si les conditions de réception ne sont pas optimales.

La demande de brevet EP 0 531 549 décrit un circuit de restitution de bits transmis par un signal asynchrone, comprenant un comparateur du niveau du signal à un seuil de discrimination ; et un circuit d'échantillonnage prenant plusieurs échantillons de la sortie du comparateur pour chaque intervalle de temps correspondant à un bit.

Un objet de la présente invention est de prévoir un circuit permettant une compensation en continu de fluctuations d'amplitude et de phase d'un signal de transmission asynchrone de bits, la fréquence de transmission et le seuil de discrimination initiaux étant, soit fixés, soit déterminés périodiquement, comme dans le cas du télétexte, à l'aide de salves de synchronisation.

Pour atteindre cet objet, la présente invention prévoit un circuit pour générer un signal d'analyse à une fréquence sensiblement égale à la vitesse de transmission des bits ; et un circuit d'analyse pour corriger le seuil de discrimination en fonction de la différence de deux valeurs de phase correspondant aux relations de phase par rapport au signal d'analyse de deux transitions consécutives des échantillons, et/ou corriger la phase du signal d'analyse par rapport à la transmission des bits en fonction de la somme des deux dites valeurs de phase.

Selon un mode de réalisation de la présente invention, chaque valeur de phase correspond au nombre d'échantillons à une même valeur séparant la transition correspondante de la plus proche frontière de la période courante du signal d'analyse, le nombre étant positif ou négatif selon que la plus proche frontière est le début ou la fin de la période.

Selon un mode de réalisation de la présente invention, le seuil de discrimination est augmenté si ladite différence est de premier signe et la première transition descendante ou si la différence est du deuxième signe et la première transition montante, et diminué sinon.

Selon un mode de réalisation de la présente invention, le circuit comprend des premier et deuxième compteurs associés respectivement auxdites différence et somme, cadencés à la fréquence du circuit d'échantillonnage, et validés en mode comptage ou décomptage en fonction de l'état d'un échantillon pris au début d'une période du signal d'analyse, de l'état du bit analysé, et du signal d'analyse.

Selon un mode de réalisation de la présente invention, le mode du premier compteur est sélectionné par l'état de l'échantillon pris au début de la période d'analyse, et le mode du deuxième compteur est sélectionné par l'état du signal d'analyse.

Selon un mode de réalisation de la présente invention, les compteurs sont validés par la sortie d'une porte OU-exclusif recevant l'état de l'échantillon pris au début de la période du signal d'analyse et l'état du bit analysé.

Ces objets, caractéristiques, et avantages ainsi que d'autres de la présente invention seront exposés plus en détail dans la description suivante de modes de réalisation particuliers, faite à titre non-limitatif à l'aide des figures jointes parmi lesquelles :
la figure 1, précédemment décrite, représente un exemple de signal de transmission de bits, commençant par une salve de synchronisation ;
la figure 2 représente schématiquement un mode de réalisation de circuit de restitution de bits selon la présente invention ;
la figure 3 représente différents cas d'analyse, selon la présente invention, d'un signal de transmission ;
la figure 4 représente partiellement un exemple détaillé de circuit de restitution de bits selon la présente invention ; et
la figure 5 représente un chronogramme illustrant le fonctionnement du circuit de la figure 4.

Dans la figure 2, un signal S de transmission asynchrone de bits est fourni à une entrée non-inverseuse d'un comparateur 14. L'entrée inverseuse du comparateur 14 reçoit une tension de référence Vref fournie par un convertisseur numérique/analogique 16. Le convertisseur 16 sert à fournir un seuil de discrimination ajustable correspondant à la tension Vref.

La sortie du comparateur 14 est fournie à un registre à décalage 18 de N bits, par exemple 7 bits. Ce registre à décalage est validé par un signal NCK de fréquence N fois supérieure à la vitesse de transmission nominale des bits. Ainsi, à la fin de la transmission de chaque bit, le registre à décalage 18 contient sept échantillons de ce bit.

Un circuit d'acquisition 20 analyse le contenu du registre à décalage 18 dans des périodes successives d'un signal de synchronisation A de fréquence idéalement égale à la vitesse de transmission des bits. Ce signal d'analyse A est fourni par un diviseur 22 qui reçoit le signal d'échantillonnage NCK et, dans des conditions nominales, divise la fréquence de ce signal NCK par N (7).

Le circuit d'acquisition 20 établit à partir du contenu du registre à décalage 18, une valeur de phase Φ10 et une valeur de phase Φ01. La valeur Φ10 indique la relation de phase entre le signal d'analyse A et une transition descendante des échantillons du registre à décalage 18, et la valeur Φ01 indique la relation de phase entre le signal d'analyse et une transition montante des échantillons du registre à décalage 18. Dans les conditions nominales, les transitions coïncident avec des débuts de période du signal d'analyse. Alors, tous les échantillons du registre à décalage 18 sont à la même valeur dans chaque période d'analyse, et les valeurs φ10 et φ01 sont nulles.

Dans une période d'analyse donnée, si une transition se trouve dans la première moitié du registre à décalage (elle s'est produite peu de temps après le début de la période d'analyse), la valeur correspondante φ10 (transition descendante) ou φ01 (transition montante) est un nombre positif égal, par exemple, au nombre d'échantillons de même valeur précédant la transition. Si la transition se trouve dans la deuxième moitié du registre à décalage 18 (elle se produit peu avant la fin de la période d'analyse), la valeur correspondante φ10 ou φ01 est un nombre négatif dont la valeur absolue est égale, par exemple au nombre d'échantillons à la même valeur après la transition.

Le circuit d'acquisition 20 fournit également la valeur D du bit correspondant au contenu du registre à décalage 18. Cette valeur D est par exemple la valeur majoritaire des échantillons, ou bien la valeur médiane, c'est-à-dire la valeur de l'échantillon central du registre à décalage. Eventuellement, on prélève sur la sortie A du diviseur 22 un signal de synchronisation BCK des bits fournis sur la sortie D.

Les valeurs de phase φ10 et φ01 sont fournies à un circuit d'évaluation 24. Ce circuit d'évaluation détermine pour chaque couple de valeurs non-nulles successives (φ10, φ01) une valeur de correction de phase qui se traduit par une modification du taux de division du diviseur 22, et une valeur de correction du seuil de discrimination Vref qui se traduit par une modification de la valeur fournie au convertisseur 16.

Pour obtenir un taux de division variable, le diviseur 22 est, par exemple, un compteur jusqu'à N dont l'incrémentation par le signal NCK est inhibée pendant un ou plusieurs cycles pour augmenter le taux de division, ou accélérée en fournissant une ou plusieurs impulsions d'incrémentation supplémentaires pour diminuer le taux. La valeur fournie au convertisseur 16 est, par exemple, le contenu d'un compteur que l'on incrémente ou décrémente pour modifier le seuil Vref.

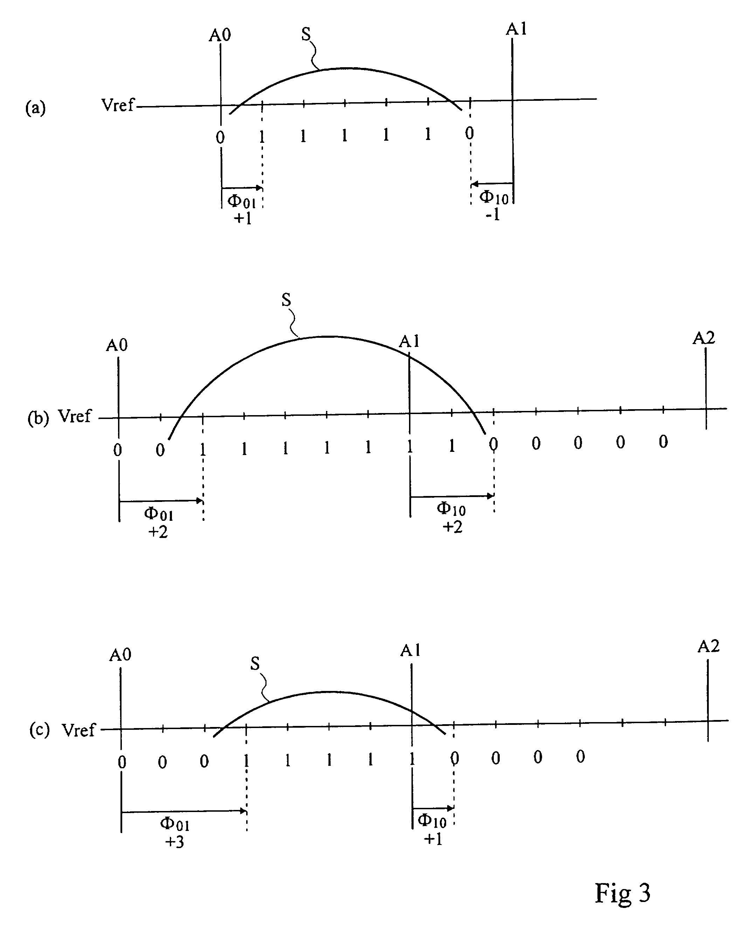

La figure 3 est destinée à illustrer comment le circuit d'évaluation 24 interprète, selon l'invention, différents exemples de cas typiques, numérotés de (a) à (c), d'évolution du signal à traiter S. Dans cet exemple, on suppose que l'on prend sept échantillons par bit. Des débuts de périodes d'analyse successives A0, A1, A2, sont indiqués par des barres verticales et les valeurs des échantillons sont indiquées sous le signal S.

Dans le cas (a), le seuil de discrimination Vref est trop élevé mais le signal d'analyse A est en phase avec la succession des bits. Le signal S dépasse le seuil Vref entre les premier et deuxième échantillons après l'instant A0, puis franchit de nouveau le seuil Vref entre les sixième et septième échantillons. Les premier et septième échantillons sont à 0 et les autres échantillons sont à 1. La valeur φ01 est égale à +1 et la valeur φ10 à -1.

Le fait que le seuil Vref soit trop élevé est détecté par une différence φ10-φ01 négative. Le fait que le signal d'analyse soit en phase avec la succession des bits est détecté par une somme φ10+φ01 nulle. Dès que le circuit d'évaluation 24 détecte ce cas, c'est-à-dire peu après l'instant A1, la valeur fournie au convertisseur numérique/analogique 16 est diminuée, par exemple en la modifiant proportionnellement à la différence φ10-φ01.

Dans le cas complémentaire, c'est-à-dire où le seuil de discrimination Vref est trop bas, le signal S commence par passer en dessous du seuil Vref peu après l'instant A0 et franchit de nouveau le seuil Vref peu avant l'instant A1. Dans ce cas, les valeurs φ10 et φ01 sont de signes opposés à ceux du cas (a) et la différence φ10-φ01 est positive. Alors, le seuil Vref est augmenté.

Dans le cas (b), le seuil Vref est à la valeur optimale, mais le signal d'analyse est en avance de phase par rapport à la succession des bits. Le signal S dépasse le seuil Vref entre les deuxième et troisième échantillons après l'instant A0, puis franchit de nouveau le seuil Vref entre les deuxième et troisième échantillons après l'instant A1. La valeur Φ01, égale à +2, trouvée à l'instant A1 est mémorisée, et la valeur Φ10, aussi égale à +2, est trouvée à l'instant A2.

La valeur optimale du seuil Vref est indiquée par le fait que la différence φ10-φ01 est nulle. L'avance de phase est indiquée par le fait que la somme φ10+φ01 est positive. Ce cas est détecté à l'instant A2 où le circuit d'évaluation dispose des deux valeurs φ10 et φ01, et la correction est effectuée en augmentant le taux de division du diviseur 22. Le taux de division est par exemple augmenté de la moitié de la somme φ10+φ01. Alors, dans l'exemple considéré, le taux de division passe de 7 à 9, ce qui a pour conséquence de retarder le prochain début de période d'analyse (A3) de deux échantillons et d'annuler l'avance de phase qui était justement de deux échantillons.

Le cas complémentaire, c'est-à-dire le retard de phase du signal d'analyse par rapport à la succession des bits est détecté lorsque la somme φ10+φ01 est négative. Alors, le taux de division du diviseur 22 est diminué, ce qui a pour conséquence d'avancer le prochain début de période d'analyse. Si le taux de division passe, par exemple, de 7 à 5, ce prochain début de période survient en avance de deux échantillons.

Le cas (c) correspond à la combinaison des cas (a) et (b), c'est-à-dire que le signal d'analyse est en avance de phase par rapport à la succession des bits et le seuil Vref est trop élevé. Les valeurs φ10 et φ01 sont respectivement égales à +1 et à +3. Ce cas est également détecté selon les règles décrites en relation avec les cas (a) et (b). En effet, le seuil Vref trop élevé est détecté par le fait que la différence φ10-φ01 est négative et l'avance de phase est détectée par le fait que la somme φ10+φ01 est positive. Les corrections apportées par le circuit d'évaluation sont celles mentionnées en relation avec les cas (a) et (b).

Les corrections de phase et du seuil peuvent être appliquées dès que les cas correspondants sont détectés, ou bien seulement si ces cas ont un caractère répétitif. En appliquant cette dernière méthode de correction, on évite des corrections erronées qui seraient provoquées par des déphasages parasites. Pour cela, par exemple, on cumule les différences φ10-φ01 et sommes φ10+φ01 successives et on applique les corrections correspondantes si le cumul dépasse un seuil prédéterminé.

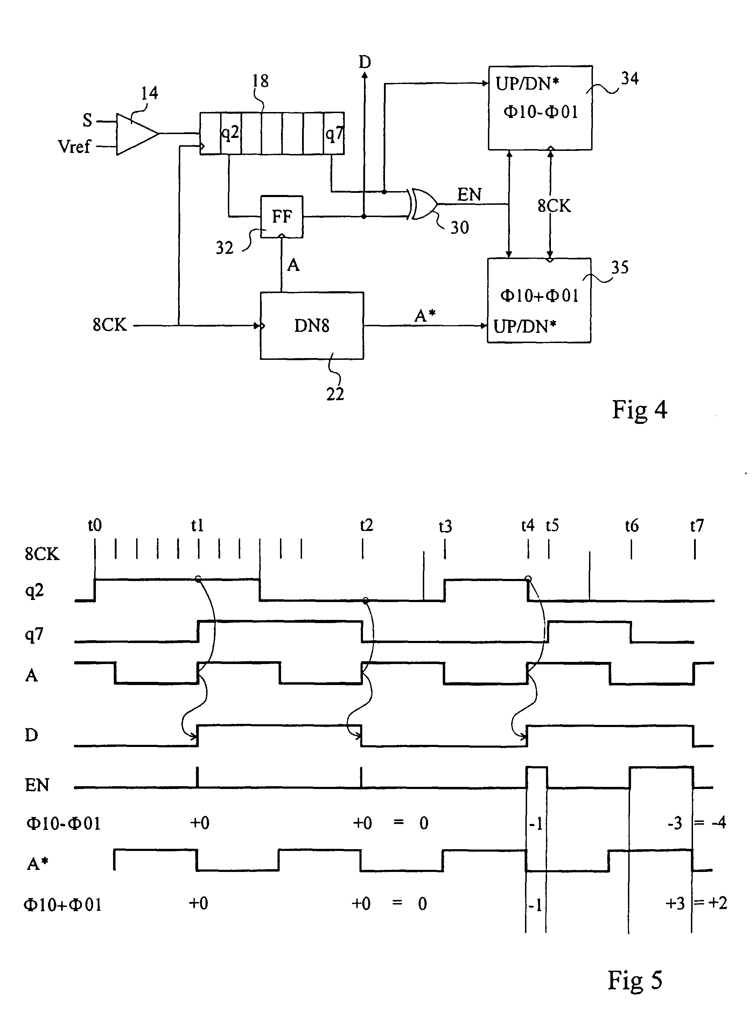

La figure 4 représente partiellement un exemple détaillé de circuit selon l'invention, effectuant une analyse en série des bits du registre à décalage 18. Ce circuit fonctionne avec huit échantillons par bit. Le registre à décalage 18, validé à une fréquence 8CK, est de sept bits dont on prélève le deuxième q2 et le septième q7. Le diviseur 22, qui divise la fréquence 8CK par 8, fournit des signaux d'analyse complémentaires A et A*. Le bit q7 est fourni directement à une première entrée d'une porte OU-exclusif 30, et le bit q2 est fourni à une bascule 32 validée par le signal A. La sortie de la bascule 32 fournit la valeur D du bit analysé et est reliée à une deuxième entrée de la porte 30. La sortie de la porte 30 fournit un signal de validation EN à deux compteurs/décompteurs 34 et 35 qui sont cadencés à la fréquence 8CK. Le compteur/décompteur 34 est associé à la différence φ10-φ01 et son sens de comptage est déterminé par le bit q7. Le compteur/décompteur 35 est associé à la somme φ10+φ01 et son sens de comptage est déterminé par le signal A*.

La figure 5 représente un chronogramme illustrant le fonctionnement du circuit de la figure 4 pour un exemple où l'on transmet les bits 1, 0, 1 et 0. Les deux premiers bits 1 et 0 sont transmis dans des conditions idéales et le troisième bit, 1, est transmis avec un seuil Vref trop élevé et en retard de phase. Les signaux d'analyse complémentaires A et A* ont un rapport cyclique de 50 %.

A un instant t0, le bit q2 passe à 1 et reste à 1 pendant 8 cycles de l'horloge 8CK.

A un instant t1, cinq cycles 8CK après l'instant t0, le bit q7 passe à 1 et reste à 1 pendant huit cycles 8CK. Le signal d'analyse A passe également à 1, ce qui provoque la mémorisation de l'état 1 du bit q2 dans la bascule 32 (le signal D passe à 1).

A un instant t2, le bit q7 passe à 0 et le signal A passe de nouveau à 1. Le signal D prend l'état 0 du bit q2.

A un instant t3, le bit q2 passe de nouveau à 1, mais avec un retard d'un cycle 8CK, et reste à 1 pendant quatre cycles 8CK au lieu de huit.

Le bit q2 passe à 0 à un instant t4, tandis que le signal A passe à 1. Le signal D a le temps de prendre l'état 1 du bit q2. Le signal D reste à 1 quoi qu'il arrive jusqu'au prochain front montant du signal A. Les signaux q7 et D sont à des valeurs distinctes et le signal EN (la sortie de la porte 30) passe à 1. Jusqu'à l'instant t4, le signal D était en phase avec l'évolution du bit q7, ce qui signifiait que l'on se trouvait dans une situation idéale, indiquée par le signal EN à 0.

A un instant t5, le bit q7 passe à 1, suivant l'évolution du bit q2 avec cinq cycles 8CK de retard. Les signaux q7 et D sont à la même valeur et le signal EN passe à 0. Le compteur 34 vient d'être validé pendant un cycle 8CK en mode décomptage (sélectionné par le bit q7 à 0). Son contenu (φ10-φ01) est donc diminué de 1. Le signal EN a également validé pendant un cycle 8CK le compteur 35 qui se trouvait en mode décomptage (signal A* à 0). Son contenu (φ10+φ01) est donc diminué de 1. Les modifications des contenus des compteurs sont illustrées dans la figure par des nombres signés.

A un instant t6, le bit q7 passe à 0 tandis que le signal D est encore à 1. Le signal EN passe de nouveau à 1 et reste à 1 jusqu'à un instant t7 où le signal D prend la valeur 0 du bit q2 au front montant du signal A. Le signal EN reste à 1 pendant trois cycles 8CK. Le compteur 34 est décrémenté de 3 (son mode décomptage est sélectionné par le bit q7 à 0) tandis que le compteur 35 est incrémenté de 3 (son mode comptage est sélectionné par le signal A* à 1).

A l'instant t7, le contenu φ10-φ01 du compteur 34 a diminué de 4, indiquant un seuil Vref trop élevé, et le contenu φ10+φ01 du compteur 35 a augmenté de 2, indiquant une avance de phase du signal A.

Comme on l'a précédemment indiqué, les corrections sont de préférence effectuées si les conditions qui en sont à l'origine sont répétitives. Pour cela, une modification du seuil Vref est effectuée à chaque fois que le compteur 34 déborde et une modification de la phase (du taux de division du diviseur 22) est effectuée à chaque fois que le compteur 35 déborde. Les modifications sont effectuées selon le sens du débordement des compteurs. En outre, une modification n'est effectuée que toutes les deux transitions des échantillons, sinon les valeurs φ10-φ01 et φ10+φ01 n'auraient aucun sens. En outre, ceci permet de tenir compte convenablement de cas limites où un compteur subit consécutivement deux débordements de sens contraires, qui ne donnent lieu à aucune correction.

Dans l'exemple des figures 4 et 5, on décrit un registre à décalage 18 de sept bits dont on utilise le deuxième et le septième. Avec cette configuration, les portions à 1 du signal d'analyse A sont centrées, dans le cas nominal, sur les transitions du signal S à analyser. Toute autre configuration est possible à condition d'utiliser deux bits de registre à décalage qui évoluent avec une différence de cinq cycles d'échantillonnage (dans l'exemple où l'on échantillonne chaque bit huit fois). En choisissant une autre configuration, on décale simplement la phase nominale du signal A par rapport aux transitions du signal S.

Le circuit selon l'invention s'applique à tout signal de transmission asynchrone de bits dont la fréquence de transmission et l'amplitude ont des valeurs nominales connues.

Bien entendu, le circuit selon l'invention s'applique également aux signaux de télétexte qui présentent périodiquement des salves de synchronisation. Dans ce cas, le circuit se sert des salves de synchronisation pour valider la phase et le seuil de discrimination obtenus jusqu'alors. Pendant une salve de synchronisation, les ajustements de phase et du seuil de discrimination sont effectués, par exemple, comme cela est décrit dans le brevet US 5 136 382 susmentionné.

## Revendications

1. Circuit de restitution de bits transmis par un signal (S) asynchrone, comprenant :
- un comparateur (14) du niveau du signal à un seuil de discrimination (Vref) ;
- un circuit d'échantillonnage (18) prenant plusieurs échantillons de la sortie du comparateur pour chaque intervalle de temps correspondant à un bit ;
caractérisé en ce qu'il comprend :
- un circuit (22) pour générer un signal d'analyse (A) à une fréquence sensiblement égale à la vitesse de transmission des bits ; et
- un circuit d'analyse (20, 24) pour corriger le seuil de discrimination en fonction de la différence de deux valeurs de phase (Φ10, Φ01) correspondant aux relations de phase par rapport au signal d'analyse de deux transitions consécutives des échantillons, et/ou corriger la phase du signal d'analyse par rapport à la transmission des bits en fonction de la somme des deux dites valeurs de phase.

2. Circuit de restitution selon la revendication 1, caractérisé en ce que chaque valeur de phase correspond au nombre d'échantillons à une même valeur séparant la transition correspondante de la plus proche frontière de la période courante du signal d'analyse (A), le nombre étant positif ou négatif selon que la plus proche frontière est le début ou la fin de la période.

3. Circuit de restitution selon la revendication 1, caractérisé en ce qu'une période ultérieure du signal d'analyse est allongée ou raccourcie en fonction de ladite somme.

4. Circuit de restitution selon la revendication 1, caractérisé en ce que le seuil de discrimination (Vref) est augmenté si ladite différence est de premier signe (+) et la première transition descendante ou si la différence est du deuxième signe (-) et la première transition montante, et diminué sinon.

5. Circuit de restitution selon la revendication 1, caractérisé en ce qu'il comprend des premier et deuxième compteurs (34, 35) associés respectivement auxdites différence et somme, cadencés à la fréquence du circuit d'échantillonnage (18), et validés en mode comptage ou décomptage en fonction de l'état d'un échantillon (q7) pris au début d'une période du signal d'analyse (A), de l'état du bit (D) analysé, et du signal d'analyse.

6. Circuit de restitution selon la revendication 5, caractérisé en ce que le mode du premier compteur est sélectionné par l'état de l'échantillon (q7) pris au début de la période d'analyse, et le mode du deuxième compteur est sélectionné par l'état du signal d'analyse (A).

7. Circuit de restitution selon la revendication 6, caractérisé en ce que les compteurs sont validés par la sortie d'une porte OU-exclusif (30) recevant l'état de l'échantillon (q7) pris au début de la période du signal d'analyse (A) et l'état du bit (D) analysé.

## Patentansprüche

1. Schaltkreis zum Wiederherstellen von Bits, die durch ein asynchrones Signal (S) übertragen wurden, mit
einem Vergleicher (14) zum Vergleichen des Signalpegels mit einem Entscheidungsschwellwert (Vref);
einem Abtastschaltkreis (18), der mehrere Abtastwerte des Vergleicherausgangs für jedes Zeitintervall, welches einem Bit entspricht, aufnimmt;
**gekennzeichnet** durch
einen Schaltkreis (22) zum Erzeugen eines Analysesignals (A) mit einer Frequenz, die ungefähr gleich der Bitübertragungsgeschwindigkeit ist; und
einen Analyseschaltkreis (20, 24) zum Korrigieren des Entscheidungsschwellwertes als Funktion der Differenz zwischen zwei Phasenwerte (φ10, φ01), welche den Phasenbeziehungen in bezug auf das Analysesignal von zwei aufeinanderfolgenden Abtastübergängen entsprechen, und/oder Korrigieren der Phase des Analysesignals in bezug auf die Bitübertragung abhängig von der Summe dieser zwei Phasenwerte.

2. Wiederherstellungsschaltkreis nach Anspruch 1, dadurch **gekennzeichnet,** daß jeder Phasenwert der Anzahl der Abtastwerte mit einem gleichen Wert entspricht, welcher den entsprechenden Übergang von der nächstliegenden Flanke der aktuellen Periode des Analysesignals (A) trennt, wobei die Zahl abhängig davon, ob die nächste Flanke der Anfang oder das Ende der Periode ist, positiv oder negativ ist.

3. Wiederherstellungsschaltkreis nach Anspruch 1, dadurch **gekennzeichnet,** daß abhängig von der Summe eine weitere Periode des Analysesignals verlängert oder verkürzt wird.

4. Wiederherstellungsschaltkreis nach Anspruch 1, dadurch **gekennzeichnet,** daß der Entscheidungsschwellwert (Vref) erhöht wird, wenn die Differenz ein erstes Vorzeichen (+) hat und der erste Übergang absteigend ist oder wenn die Differenz ein zweites Vorzeichen (-) hat und der erste Übergang aufsteigend ist, und im anderen Fall verringert wird.

5. Wiederherstellungsschaltkreis nach Anspruch 1, dadurch **gekennzeichnet,** daß er einen ersten oder einen zweiten Vergleicher (34, 35) aufweist, die jeweils der Differenz und der Summe zugeordnet sind, mit der Frequenz des Abtastschaltkreises (18) getaktet sind und abhängig von dem Zustand eines Abtastwertes (q7), der am Anfang einer Periode des Analysesignals (A) aufgenommen wird, dem analysierten Bitzustand (D) und dem Analysesignal in den Aufwärts- oder Abwärtszählmodus gesetzt werden.

6. Wiederherstellungsschaltkreis nach Anspruch 5, dadurch **gekennzeichnet,** daß der Modus des ersten Zählers durch den Zustand des Abtastwertes (q7) am Anfang der Analyseperiode bestimmt wird und der Modus des zweiten Zählers durch den Zustand des Analysesignals (A) bestimmt wird.

7. Wiederherstellungsschaltkreis nach Anspruch 6, dadurch **gekennzeichnet,** daß die Zähler durch das Ausgangssignal eines Exklusiv-ODER-Gatters (30) aktiviert werden, welches den Zustand des Abtastwertes (q7) am Anfang der Periode des Analysesignals (A) und den Zustand des analysierten Bits (D) empfängt.

## Claims

1. A circuit for restoring bits transmitted by an asynchronous signal (S), including:
- a comparator (14) of the signal level with a discrimination threshold (Vref);
- a sampling circuit (18) taking several samples from the comparator output for each time interval corresponding to a bit;
characterized in that it comprises:
- a circuit (22) for generating an analysis signal (A) at a frequency substantially equal to the bit transmission speed; and
- an analysis circuit (20, 24) for correcting the discrimination threshold according to the difference between two phase values (φ10, φ01) corresponding to the phase relationships with respect to the analysis signal of two consecutive sample transitions, and/or correct the phase of the analysis signal with respect to the bit transmission according to the sum of said two phase values.

2. A restoring circuit according to claim 1, characterized in that each phase value corresponds to the number of samples at a same value separating the corresponding transition from the nearest border of the current period of the analysis signal (A), the number being positive or negative according to whether the nearest border is the beginning or the end of the period.

3. A restoring circuit according to claim 1, characterized in that a further period of the analysis signal is lengthened or shortened according to said sum.

4. A restoring circuit according to claim 1, characterized in that the discrimination threshold (Vref) is increased if said difference has a first sign (+) and the first transition is downward or if the difference has a second sign (-) and the first transition is upward, and otherwise decreased.

5. A restoring circuit according to claim 1, characterized in that it includes first and second comparators (34, 35) respectively associated with said difference and sum, at the rate of the frequency of the sampling circuit (18), and enabled in the counting or down counting mode according to the state of a sample (q7) taken at the beginning of a period of the analysis signal (A), to the bit state (D) analyzed, and to the analysis signal.

6. A restoring circuit according to claim 5, characterized in that the mode of the first counter is selected by the state of the sample (q7) taken at the beginning of the analysis period, and the mode of the second counter is selected by the state of the analysis signal (A).

7. A restoring circuit according to claim 6, characterized in that the counters are enabled by the output of an exclusive-OR gate (30) receiving the state of the sample (q7) taken at the beginning of the period of the analysis signal (A) and the state of the bit (D) analyzed.
